(19) Europäisches Patentamt
European Patent Office
Office européen des brevets

(11) **EP 3 221 392 B1**

(12) **EUROPEAN PATENT SPECIFICATION**

(45) Date of publication and mention
of the grant of the patent:
**19.09.2018 Bulletin 2018/38**

(51) Int Cl.:
*C08J 3/00* (2006.01)    *C08J 3/18* (2006.01)
*C08J 3/20* (2006.01)    *C08L 27/12* (2006.01)
*C08K 3/38* (2006.01)    *C09K 5/14* (2006.01)
*C08J 5/18* (2006.01)    *H01L 23/373* (2006.01)

(21) Application number: **15808302.2**

(22) Date of filing: **19.11.2015**

(86) International application number:
**PCT/US2015/061450**

(87) International publication number:
**WO 2016/081673 (26.05.2016 Gazette 2016/21)**

(54) **MELT PROCESSIBLE FLUOROPOLYMER COMPOSITION WITH EXCELLENT HEAT CONDUCTIVITY, MOLDED PRODUCT MANUFACTURED FROM THE COMPOSITION AND MANUFACTURING METHOD**

SCHMELZVERARBEITBARE FLUORPOLYMERZUSAMMENSETZUNG MIT AUSGEZEICHNETER WÄRMELEITFÄHIGKEIT, AUS DER ZUSAMMENSETZUNG HERGESTELLTES FORMPRODUKT UND HERSTELLUNGSVERFAHREN

COMPOSITION DE FLUOROPOLYMÈRE POUVANT ÊTRE TRAITÉ À L'ÉTAT FONDU PRÉSENTANT UNE EXCELLENTE CONDUCTIVITÉ THERMIQUE, PRODUIT MOULÉ FABRIQUÉ À PARTIR DE LA COMPOSITION ET PROCÉDÉ DE FABRICATION

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **20.11.2014 JP 2014235955**

(43) Date of publication of application:
**27.09.2017 Bulletin 2017/39**

(73) Proprietor: **DuPont-Mitsui Fluorochemicals Company, Ltd.**
**Tokyo 105-0001 (JP)**

(72) Inventors:
• **NAM, Pham Hoai**
Shizuoka-shi
Shizuoka 424-8631 (JP)
• **NODA, Mineyuki**
Shizuoka-shi
Shizuoka 424-8631 (JP)
• **NAKA, Kazuhiko**
Shizuoka-shi
Shizuoka 424-8631 (JP)
• **HAYAKAWA, Osamu**
Shizuoka-shi
Shizuoka 424-8631 (JP)

(74) Representative: **Dannenberger, Oliver Andre et al**
**Abitz & Partner**
**Patentanwälte mbB**
**Arabellastrasse 17**
**81925 München (DE)**

(56) References cited:
**WO-A1-2015/134233    WO-A2-2008/042446**
**JP-A- 2005 343 728**

• **M. INOUE ET AL: "Effects of Multi-modal Filler Size Distributions on Thermal Conductivity of Electrically Conductive Adhesives Containing Ag Micro and Nanoparticles", TRANSACTIONS OF THE JAPAN INSTITUTE OF ELECTRONICS PACKAGING, vol. 2, no. 1, 1 January 2009 (2009-01-01), pages 125-133, XP55191490, ISSN: 1883-3365, DOI: 10.5104/jiepeng.2.125**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

**Description**

**CROSS-REFERENCES TO RELATED APPLICATIONS**

This application claims the benefit of Japanese Patent Application No. 2014-235955 filed November 20, 2014.

**FIELD OF THE INVENTION**

The present invention relates to a melt processible fluoropolymer composition with excellent heat conductivity, electrical properties, and moldability.

**BACKGROUND TECHNOLOGY**

Heat is increased with miniaturization and higher integration of semiconductors, and therefore, heat dissipating materials with high heat conductivity and high insulating properties must be used as materials to configure a semiconductor. Particularly, generated heat is greater with power semiconductors used for power control and power modules incorporating power semiconductor elements, and therefore, heat dissipating materials that can efficiently diffuse heat are desired. To efficiently eliminate heat, not only high heat conductivity in the heat dissipating material is required, but also contacting the heat generating body without any gaps. Particularly, the heat dissipating material preferably has flexibility so cracks and defects are not generated in an environment with high vibration.

A ceramic sheet is in practical use as the heat dissipating material with high heat conductivity and high insulating properties, but the ceramic sheet has inferior workability and poor flexibility, and defects due to cracking may occur. The concern is greater particularly in an environment with severe vibration or large changes in temperature. Furthermore, another drawback is that the weight is heavy, depending on the application. Furthermore, applying a heat conductive grease in between the ceramic sheet and a cooling target is necessary for the ceramic sheet to come in contact with a cooling target, and there is a problem of increased cost. A heat conductive polymer composition made of polymer and heat conductive filler has also been proposed, but heat conductivity is still insufficient. Furthermore, if using a thermoset polymer as the polymer, there is a drawback of the polymer not having flexibility after curing. Furthermore, silicone or epoxy polymers that are actually frequently used as the thermoset polymer do not have sufficient insulating properties, and if used for a long period of time at high temperatures, the polymer deteriorates and maintaining physical properties becomes difficult. Therefore, in an environment where vibration is severe or with a large temperature change, cracking may occur or the polymer may deteriorate, and problems remain with use for a long period of time.

The amount of heat transfer of objects with temperature difference is better if the object has a large heat conducting area and the distance between the objects is small. Therefore, to improve the cooling efficiency of a power semiconductor, the heat dissipating material is preferably in a thin sheet form, and the cooling performance is improved if the thickness of the sheet is thinner. However, insulating properties and strength of the sheet tend to reduce if the sheet is too thin, and this is not preferable. In other words, a heat dissipating material with properties of such as large heat conductivity, thinness, flexibility, strength, and high insulating properties, is preferable for cooling applications for power semiconductors.

On the other hand, fluoropolymer has excellent thermal resistance, electricity insulating properties, low dielectric constant, and excellent chemical resistance compared to other polymers, and therefore, is used for all types of electric materials such as a material for electrical circuit. Particularly perfluoropolymers where the hydrogen of the molecular chain is completely replaced with fluorine has particularly excellent properties (excellent thermal resistance, electricity insulating properties, low dielectric constant, and excellent chemical resistance). However, most perfluoropolymers are insoluble in solvents, and therefore, performing dry blending, melt mixing, or the like is necessary to mix the filler. With thermoset polymers such as soluble polymers or silicone or epoxy polymers, a polymer or polymer composition in which the filler is easily sufficiently dispersed is obtained by a method where the filler in a solution of a precursor is dispersed before cross-linking, and then dried and cured. Compared to polymers that can be mixed with the varnish method, dispersing the filler in the perfluoropolymer has the following problems.

(1) When melt mixing, dispersing the filler is difficult because the melt viscosity is high. (2) When melt mixing, the filler is easily destructed because the melt viscosity is high and stress is applied to the filler. (3) When melt mixing, air remains in the gaps of the filler because the melt viscosity is high and voids are easily formed. (4) Particularly, when a fine filler is added, melt viscosity of the composition increases and the problems (filler not easily dispersed, filler destructed by pressure, voids forming) mentioned in (1) through (3) are more likely to occur. In other words, a heat dissipating material that has large heat conductivity, thinness, and flexibility, with properties of high strength and high insulating properties, is preferable for cooling applications for power semiconductors.

Boron nitride (BN) is known as a filler with good heat conductivity and insulating properties, and BN particles made of flat plate BN that is non-oriented and aggregated is in practical use to resolve the problem of the orientation of heat conductivity based on the filler form (Patent Document 1). However, heat conductivity of the sheet obtained by Patent Document 1 is low at approximately 4.76 W/mK in the thickness direction, which is insufficient.

Patent Document 2 discloses a fluoropolymer and a heat conducting sheet with conducting properties made of inorganic particles (boron nitride) with heat conductivity. However, the sheet obtained by the document requires a complex process of overlapping a plurality of sheet-shaped molded bodies and rolling, and therefore, has a problem of productivity. Furthermore, the obtained sheet is a sheet where the heat conductivity in the in-plane direction is higher than the heat conductivity in the thickness direction. Furthermore, in order to achieve high heat conductivity, 90 weight% of boron nitride must also be included, and there are problems in terms of cost and moldability.

Patent Document 3 discloses a composition with heat conductivity made of melt processible fluoropolymer and filler with heat conductivity. However, the fluoropolymer uses dispersion (dispersing solution), and forms a coating film by coating, and therefore, the form can only be a thin film. Furthermore, heat conductivity of the obtained film is low, at most 3 to 4 W/mK, which is insufficient.

Patent Document 4 discloses a composition made of rubber and polymer in which at least one contains two types of boron nitride powder with a maximum value B in a range of 5 to 30 $\mu$m and a maximum value A in a range of 100 to 300 $\mu$m, based on the frequency particle diameter distribution. However, the heat conductivity of all of the obtained polymer compositions are low at 2 W/mK or lower, which is insufficient.

## PRIOR TECHNOLOGY DOCUMENTS

### Patent documents

Patent Document 1: Japanese Patent No. 3461651

Patent Document 2: Japanese Unexamined Patent Application 2010-137562

Patent Document 3: Japanese Unexamined Patent Application 2013-23664

Patent Document 4: Japanese Unexamined Patent Application 2005-343728

Patent Document 5: Japanese Unexamined Patent Application 2012-056818

Patent Document 6: Japanese Patent No. 5305656

## SUMMARY OF THE INVENTION

### Problem to be resolved by the invention

An object of the present invention is to provide: a melt processible fluoropolymer composition with excellent insulation properties, heat conductivity, and thermal resistance, that is suitable as a raw material for a molded product having flexibility and excellent moldability; a molded product manufactured from the melt processible fluoropolymer composition, particularly a thin (for example, 300 $\mu$m or less) sheet-shaped molded product; and a manufacturing method thereof.

## MEANS FOR RESOLVING THE PROBLEM

Therefore, as a result of extensive studies to resolve the aforementioned problem, the present inventors discovered that by including a combination of a melt processible fluoropolymer and two types of boron nitride particles [particles (A) and particles (B)] with a different particle diameter as a filler at a predetermined ratio, a polymer composition with excellent heat conductivity and high insulating properties, and that is a raw material for a molded product having excellent flexibility can be prepared, thereby leading to the present invention.

A first aspect of the present invention relates to a melt processible fluoropolymer composition. First, the present invention is a polymer composition, containing: 30 to 60 volume% of a melt processible fluoropolymer; and 40 to 70 volume% of boron nitride particle; wherein the boron nitride particles include particles (A) and particles (B), the particles (A) are spherical aggregate particles with an average particle diameter of 60 $\mu$m or higher to 100 $\mu$m, and an aspect ratio of 1 to 2, the particles (B) are particles with an average particle diameter of 8 to less than 50 $\mu$m, and the volume ratio of the particles (A) based on the total amount of boron nitride is 80 to 99 volume%.

Furthermore, in the present invention, the boron nitride particles (B) are preferably spherical aggregate particles with an aspect ratio of 1 to 2, and the melt flow rate (MFR) of the melt processible fluoropolymer is preferably within a range of 5 to 100 g / 10 minutes. In the present invention, the fluoropolymer is preferably a perfluoropolymer.

Furthermore, in the present invention, the ratio of the melt processible fluoropolymer is preferably 35 to 50 volume% and the ratio of the boron nitride is preferably 50 to 65 volume%, and the average particle diameter of the particles (A) is preferably 60 to 90 $\mu$m and the average particle diameter of the particles (B) is preferably 10 to 50 $\mu$m.

A second aspect of the present invention is a molded product manufactured from the melt processible fluoropolymer composition of the present invention. The molded product is preferably a sheet-shaped molded product with a thickness within a range of 100 to 300 $\mu$m.

A third aspect of the present invention is a method of manufacturing the molded product from the melt processible fluoropolymer composition of the present invention. More specifically, an aspect of the present invention is a method of manufacturing a sheet-shaped molded product, including: a step of mixing melt processible fluoropolymer and boron nitride particles at a ratio of 30 to 60 volume% to 40 to 70 volume%, such that the boron nitride particles are made from particles (A) and particles (B), the particles (A) are spherical aggregate particles with an average particle diameter of 60 $\mu$m or higher to 100 $\mu$m, and an aspect ratio of 1 to 2, the particles (B) are particles with an average particle diameter of 8 to less than 50 $\mu$m , and the volume ratio of the particles (A) to the total amount of boron nitride is 80 to 99 volume%; and a step of obtaining a sheet-shaped molded product by melt molding the mixed melt processible fluoropolymer composition.

## EFFECT OF THE INVENTION

The molded product (for example, sheet of the present invention) from the melt processible fluoropolymer composition from the present invention has excellent heat conductivity, high insulating properties, and excellent flexibility as compared to a ceramic molded body or thermoset polymer composition. A sheet of the present invention has high heat conductivity, and therefore, is useful as a heat dissipating material of a semiconductor, particularly a heat dissipating material for a power semiconductor, and is useful as a printed substrate material, substrate material for a compact power source, and a sealing material for a secondary cell and the like. Furthermore, the melt processible fluoropolymer composition of the present invention is particularly suitable in thin (for example, 300 $\mu$m or less) sheet-shaped molded products.

## DESCRIPTION OF THE PREFERRED EMBODIMENTS

### <1> Polymer Composition of the Present Invention

The first aspect of the present invention is a polymer composition containing a melt processible fluoropolymer and boron nitride particles.

(1) Melt processible fluoropolymer

The "melt processible fluoropolymer" used in the present invention can be appropriately selected from polymers that are known as melt processible fluoropolymers. Examples can include: polymers or copolymers of monomers selected from tetrafluoroethylene, chlorotrifluoroethylene, hexafluoropropylene, perfluoro (alkyl vinyl ether), vinylidene fluoride, and vinyl fluoride; copolymers between these monomers and monomers having a double bond such as propylene, butylene, pentylene, hexene, and the like, or monomers having a triple bond such as acetylene, propyne, and the like. Examples of specific melt processible fluoropolymers can include tetrafluoroethylene-perfluoro (alkyl vinyl ether) copolymers (PFA), tetrafluoroethylene-hexafluoropropylene copolymers (FEP), tetrafluoroethylene-hexafluoropropylene-perfluoro (alkyl vinyl ether) copolymers, tetrafluoroethylene-ethylene copolymers, polyvinylidene fluoride, polychlorotrifluoroethylene, chlorotrifluoroethylene-ethylene copolymers, and the like.

Furthermore, in the present invention, fluoroelastomer (fluoroelastomer) that is polymerized from the aforementioned fluorine monomers and non-fluorine monomers can also be used as the melt processible fluoropolymer of the present invention. Fluoroelastomer (fluoroelastomer) in a non-crosslinked state demonstrates flowability by heating, and is soluble in a solvent, and therefore, is favorable as the melt processible fluoropolymer of the present invention. Specific examples can include vinylidene fluoride-hexafluoropropylene copolymers, vinylidene fluoride-hexafluoropropylene-tetrafluoroethylene copolymers, and the like. A crosslinking agent (polyamine, peroxide, polyol) is added as needed, and thus moldability, thermal resistance, adhesion, and the like can be controlled. An example of the fluoroelastomer can include Viton (registered trademark) manufactured by DuPont.

Of these melt processible fluoropolymers, perfluoropolymers such as PFA, FEP, and tetrafluoroethylene-hexafluoropropylene-perfluoro (alkyl vinyl ether) copolymers, in particular, are preferably used from the perspective of chemical stability, thermal resistance, insulating properties, and electrical properties (dielectric constant and dielectric loss). If PFA is used, an alkyl group of perfluoro (alkyl vinyl ether) in the PFA preferably has 1 to 5 carbon atoms and more preferably 1 to 3.

Furthermore, a perfluoropolymer having flowability at a temperature that is at the melting point or higher, specifically having a melt flow rate (MFR) at a value that is greater than 1 g/10 minutes is preferred, from the perspective of moldability when melting at a high temperature. Examples of this polymer can include PFA, FEP, and tetrafluoroethylene-hexafluoropropylene-perfluoro (alkyl vinyl ether) copolymers. PFA with a high melting point and excellent heat flowability is particularly preferable. Based on the required characteristics, two or more types of the melt processible fluoropolymer can also be blended and used.

From the perspective of thermal resistance, the melting point of the melt processible fluoropolymer is preferably 200°C or higher, more preferably 250°C or higher, and even more preferably 300°C or higher. If PFA or FEP is used as the melt processible fluoropolymer of the present invention, the melt flow rate (MFR) thereof is preferably 1 g/10 minutes or more, more preferably 5 g/10 minutes or more, even more preferably 10 g/10 minutes or more, and particularly preferably 30 g/10 minutes or more. By selecting a raw material that is a melt processible fluoropolymer with high flowability when melting, effects are achieved such as the polymer easily enters gaps between filler particles when the melt processible fluoropolymer composition is melt molded, a filler structure is prevented from destruction due to a physical load applied to the filler due to high melt viscosity, and the like.

On the other hand, when the flowability during melting is too high, in other words, when the molecular weight of the melt processible fluoropolymer is too low, molecular entanglement will be reduced and the polymer will be brittle at temperatures below the melting point or glass transition temperature, and as a result, the flexibility of the molded product will be reduced, and there will be a tendency for the product to be brittle and prone to breaking, which is not preferable. Therefore, from the perspective of improving flexibility, if PFA or FEP is used, the MFR is preferably 100 g/10 minutes or less, more preferably 80 g/10 minutes or less, more preferably 70 g/10 minutes or less, and particularly preferably 60 g/10 minutes or less. The composition ratio (comonomer content) of the monomers of the melt processible fluoropolymer of the present invention that form the copolymer is not particularly regulated, but can be appropriately adjusted based on the flexibility, hardness, and strength required of the polymer.

When the aforementioned is generalized, if a perfluoropolymer is used as the melt processible fluoropolymer of the present invention, the MFR is preferably 1 to 100 g/10 minutes, more preferably 5 to 80 g/10 minutes, even more preferably 10 to 70 g/10 minutes or higher, and particularly preferably 30 to 60 g/10 minutes.

(2) Boron Nitride Particles of the Present Invention

The composition of the present invention contains boron nitride particles (hereinafter sometimes referred to as "BN") as a filler. The boron nitride particles of the present invention include boron nitride particles (A) and boron nitride particles (B).

*(A) Boron Nitride Particles (A)*

The boron nitride particles (A) are spherical aggregate particles with an average particle diameter of 60 μm or higher to 100 μm and an aspect ratio (long diameter/short diameter of spherical particles) of 1 to 2. The spherical boron nitride aggregate particles are particles with a spherical shape and an aggregate of primary particles of boron nitride. The spherical aggregate particles are preferably aggregates of flat primary particles. The spherical aggregate particles can be manufactured using the methods described in patent document 5 and patent document 6 for example. Specific examples of the particles can include FP70 manufactured by Denki Kagaku Kogyo K.K., PTX60 manufactured by Momentive Performance Material Inc., and the like.

The aspect ratio of the boron nitride particles (A) of the present invention is 1 to 2. When the aspect ratio of the boron nitride particles (A) is more than 2, the boron nitride particles will be oriented in the flow direction during melt molding due to the molding conditions, in the molded product formed from the fluoropolymer composition, and therefore, a problem can occur where the heat conductivity in a specific direction is reduced. Furthermore, when a thin sheet is formed, the distance that the filler can move inside during press molding is short, and therefore, when the aspect ratio is higher than 2 (when an anisotropic shape), flow in a specific direction will be difficult, and the filler may not be evenly distributed, and as a result, problems may occur where the strength of the formed sheet is reduced, or a space (void) is formed in the sheet.

The average particle diameter of the boron nitride particles (A) of the present invention is 60 μm or higher to 100 μm. By using boron nitride particles with a large particle diameter within this range, the interface between the polymer / filler can be reduced in the molded product manufactured from the polymer composition, and an efficient heat conduction path can be formed, and thus the heat conductivity can be enhanced. When the average particle diameter of the particles (A) is less than 55 μm, the moldability of the polymer composition will deteriorate and the heat conductivity of the manufactured molded product will be reduced, due to an increase in melt viscosity. On the other hand, when the average particle diameter of the particles (A) exceeds 100 $\mu$m , the boron nitride particles will easily be destroyed when a thin sheet (300 $\mu$m or less) is prepared as the manufactured molded product. Furthermore, there are problems where the strength of the sheet is reduced, and the breakdown voltage of the sheet which is the molded product is reduced due to spaces (voids) easily forming in the sheet. From this perspective, the average particle diameter of the particles (A) is more preferably 60 to 90 $\mu$m.

Note that in the present specification, "average particle diameter" refers to the particle diameter at an integrated value of 50% (volumetric basis) of the particle diameter distribution obtained by a laser diffraction and scattering method.

*(B) Boron Nitride Particles (B)*

The boron nitride particles (B) of the present invention are particles with an average particle diameter that is 8 to less than 50 $\mu$m. As described above, the average particle diameter of the boron nitride particles (A) is 60 $\mu$m or higher to 100 $\mu$m, and therefore, by combining boron nitride particles (B) with a smaller particle diameter than the boron nitride particles (A), more efficient packing is possible as compared to only using boron nitride particles (A) when a thin sheet that is 300 $\mu$m or less is melted and compression molded, and as a result, an efficient heat conduction path can be formed.

If the average particle diameter of the particle (B) is less than 8 $\mu$m , in other words, when the ratio of fine particles increases, sufficient mixing will not be achieved due to the melt viscosity of the polymer composition increasing, and destruction of the boron nitride particle will occur, and as a result, a sufficient heat conduction path cannot be formed in the molded product. Furthermore, when the amount of fine particles increases, problems will occur where the interface between the boron nitride/polymer and between the boron nitride/boron nitride increases, thermal resistance increases, and heat conductivity is reduced. On the other hand, when the average particle diameter of the particles (B) exceeds 50 $\mu$m , a problem will occur where a heat conduction path is not sufficiently formed due to efficient packing. From this perspective, the average particle diameter of the particles (B) is more preferably 10 to 50 $\mu$m, even more preferably 20 to 50 $\mu$m , and particularly preferably 25 to 50 $\mu$m.

The average particle diameter of the boron nitride particles (B) is preferably 0.15 times or higher than the average particle diameter of the boron nitride particles (A), more preferably 0.2 times or higher, even more preferably 0.3 times or higher, and most preferably 0.4 times or higher. When the particles (B) are too small as compared to the particles (A), in other words, when less than 0.15 times the particles (A), the interface between the boron nitride / polymer and between the boron nitride / boron nitride increases, the thermal resistance increases, and the heat conductivity decreases, which is not preferable. The average particle diameter of the boron nitride particle (B) is preferably 0.8 times or less than the average particle diameter of the boron nitride particles (A), and more preferably 0.7 times or less. When the particles (B) are too large as compared to the particles (A), in other words, when more than 0.8 times the particles (A), a heat conduction path cannot be sufficient formed due to efficient packing, which is not preferable.

When the aforementioned is generalized, the average particle diameter of the boron nitride particles (B) is preferably within a range of 0.15 to 0.8 times the average particle diameter of the boron nitride particles (A), more preferably within a range of 0.2 to 0.8 times the average particle diameter of the particles (A), even more preferably within a range of 0.3 to 0.7 times, and most preferably within a range of 0.4 to 0.7 times. When the average particle diameter of the particles (B) is within this range, a heat conduction path structure will be efficiently formed in the molded product with a thin sheet shape, which is preferable.

Boron nitride particles that have a flat, spherical, irregular or other shape can be used as the boron nitride particles (B), but similar to the boron nitride particles (A), spherical aggregate particles with an aspect ratio of 1 to 2 are preferably used. The spherical aggregate particles are more preferably aggregates of flat primary particles. Because the particles are spherical, movement during melt molding is easy, and if a thin sheet is formed, the particles (B) can be easily packed in between the grains of the particles (A). Furthermore, the spherical aggregate particles do not have heat conductive anisotropy, and therefore, a heat conduction path is more efficiently formed. Furthermore, movement during melt molding is easy and dispersion is easy, and therefore, spaces (voids) forming in the molded product will be difficult, and as a result, a molded product that is uniform and has heat conductivity can be manufactured. Specific examples of the particles can include SGPS manufactured by Denki Kagaku Kogyo K.K. and FP40 manufactured by the same company.

Note that the boron nitride anisotropic particles are particles of boron nitride having a flat plate shape due to the crystal structure and are generally available. The "aspect ratio" of the "boron nitride anisotropic particles" is calculated as "average particle diameter/flat plate thickness"

(3) Composition Ratio of Boron Nitride Particles

The melt processible fluoropolymer composition of the present invention has a volume ratio of the particles (A) to the total amount of boron nitride of 80 to 99 volume %. Of the total amount of boron nitride, the volume ratio of the particles (A) is preferably 85 to 98 volume%, even more preferably 90 to 98 volume%, and particularly preferably 93 to 98 volume%.

Note that "total amount of boron nitride" refers to the total amount of the particles (A) and particles (B), but if boron nitride of other shapes are included, an amount including this boron nitride is the "total amount of boron nitride".

(4) Composition Ratio of Melt processible fluoropolymer and Boron Nitride Particles

The present invention is a polymer composition containing 30 to 60 volume% of the melt processible fluoropolymer and 40 to 70 volume% of the boron nitride particles. The volume composition ratio of the boron nitride particles that comprise the melt processible fluoropolymer composition of the present invention is 70 volume% or less, preferably 65 volume% or less, and more preferably 60 volume% or less.

When the volume composition ratio of the boron nitride particles exceeds 70 volume%, processing will be difficult due to the melt viscosity increasing and moldability of the polymer deteriorating, and the flexibility of the molded product such as a manufactured sheet and the like will be reduced, causing the product to become brittle. In particular, if a thin (for example, 100 to 300 $\mu$m) sheet is molded, the melt processible fluoropolymer will not be completely filled between the boron nitride (aggregate) particles), and a space (void) may form. In particularly, when the thin (100 to 300 $\mu$m) sheet is molded, the moving distance of the boron nitride (aggregate) particles will be short and the degree of freedom will be low in melt compression during molding, and therefore, overlapping particles will easily be destroyed, but by increasing the amount of polymer, the freedom of movement will be increased and packing will be easier without destroying the particles, which is preferable. Furthermore, when the boron nitride is excessive, the cost will increase, and problems will occur in that the boron nitride particles are easily destroyed in the manufacturing step of the molded product, the particle/particle interface and the particle/polymer interface increases, and the thermal resistance of the molded product such as a sheet or the like increases, and therefore, the heat conductivity is reduced. On the other hand, in order to achieve the required heat conductivity, 40 volume% or more of boron nitride must be included, preferably 45 volume% or more is include, and more preferably 50 volume% or more is included.

Furthermore, in the polymer composition of the present invention, 30 to 60 volume% of the melt processible fluoropolymer is included, and therefore, a flexible molded product can be prepared by the melt processible fluoropolymer that is included. The polymer composition of the present invention includes 30 volume% or more of the melt processible fluoropolymer, and therefore, a bent sheet can be prepared without cracking when bending. Furthermore, the obtained sheet is suitable as a dissipating material in which flexibility is required, particularly because the dissipating material having flexibility tracks vibrations in an environment where vibrations are severe. Furthermore, when considering the content of the boron nitride particles, the amount of melt processible fluoropolymer is 60 volume% or less in the polymer composition, preferably 55 volume% or less, and more preferably 50 volume% or less. When the aforementioned is generalized, in the polymer composition of the present invention, the ratio of the melt processible fluoropolymer is preferably 35 to 50 volume%, and the ratio of the boron nitride particles is preferably 50 to 65 volume%.

(5) Optional Additives

A filler other than the boron nitride particles such as an inorganic filler or organic filler can be appropriately added to the melt processible fluoropolymer composition of the present invention, depending on the required properties. Furthermore, one or more type of other conventional additive such as stabilizers (heat stabilizers, ultraviolet absorbers, light stabilizers, antioxidants, and the like), dispersing agents, antistatic agents, coloring agents, lubricants, and the like can be used in the melt processible fluoropolymer composition of the present invention.

## <2> Molded Product of the Present Invention

The second aspect of the present invention is a molded product manufactured from the melt processible fluoropolymer composition of the present invention by melt molding. The molded product of the present invention preferably has a sheet shape with a thickness within a range of 100 to 300 $\mu$m. The molded product of the present invention contains the two types of particles (A) and particles (B) obtained in the manner described above at a predetermined ratio, and therefore, an efficient conduction path is formed between the boron nitride particles, and as a result, high heat conductivity can be provided. The heat conductivity of the molded product of the present invention is preferably 8.0 W/mK or higher and more preferably 10.0 W/mK or higher. The molded product of the present invention contains two types of particles with different sizes, and the polymer is provided in the spaces between the particles, and therefore, excellent flexibility is provided.

### <3> Manufacturing Method of the Present Invention

The molded product of the present invention is formed by a conventionally known melt molding method after adding other additives or the like as needed to the boron nitride particles and melt processable fluoropolymer of the raw materials of the present invention and then mixing. In other words, in the method of manufacturing the molded product of the present invention from the melt processable fluoropolymer composition of the present invention, manufacturing is possible by mixing the melt processable fluoropolymer, fillers, and as needed, additives, and then molding at a temperature and pressure at which the melt processable fluoropolymer will melt. More specifically, manufacturing is possible using the following method for example.

An aspect of the present invention is a method of manufacturing a sheet-shaped molded product, including: a step of mixing melt processable fluoropolymer and boron nitride particles at a ratio of 30 to 60 volume% to 40 to 70 volume%, such that the boron nitride particles are made from particles (A) and particles (B), the particles (A) are spherical aggregate particles with an average particle diameter of 60 $\mu$m or higher to 100 $\mu$m, and an aspect ratio of 1 to 2, the particles (B) are particles with an average particle diameter of 8 to less than 50 $\mu$m, and the volume ratio of the particles (A) to the total amount of boron nitride is 80 to 99 volume%; and a step of obtaining a sheet-shaped molded product by melt molding the mixed melt processable fluoropolymer.

The mixing step and melt molding step are described below.

(A) Mixing Step

The melt processable fluoropolymer composition of the present invention contains the melt processable fluoropolymer and boron nitride particles as described above. The spherical aggregate particles are included in the polymer composition of the present invention as the boron particles (A), and therefore, there is a possibility that the spherical aggregate particles will be destroyed due to a shearing force during mixing in a melt kneading method where the polymer is mixed in a melted state. Therefore, the step of mixing is preferably performed in a non-molten state, using a dry blending, wet mixing, or co-aggregating method.

In dry blending, the melt processable fluoropolymer, boron nitride particles, and an arbitrary additive are mixed in a dry state and then mixed using a commonly used mixer to obtain a mixed composition. Furthermore, in wet mixing, the melt processable fluoropolymer and boron nitride particles are dissolved or dispersed in a liquid to be a solvent or dispersion medium to obtain a liquid or slurry mixed composition. Furthermore, using the co-aggregating method, a mixed composition can also be obtained by appropriately dispersing the boron nitride particles, dispersion liquid of the melt processable fluoropolymer, and the like in a liquid and then stirring and aggregating.

A liquid such as water, an organic solvent or the like can be used as the solvent or dispersing medium when wet mixing. A liquid having solubility or dispersability with regards to the melt processable fluoropolymer is preferably used as the solvent or dispersion medium. For the melt processable fluoropolymer of the present invention, an organic solvent with low surface energy is preferably used and a fluorine solvent containing fluorine is preferably used as the dispersion medium, in order to properly disperse the PFA particles if PFA is used. From the perspective of environmental impact, a hydrofluorocarbon (HFC) containing carbon, fluorine and hydrogen, or a hydrofluoroether (HFE) containing an ether bond is preferably used as the fluorine solvent. Specific examples include: Vertrel (registered trademark) XF (1,1,1,2,2,3,4,5,5,5-decafluoropentane) or Vertrel (registered trademark) Suprion (trademark) (methoxy-perfluoroheptane), manufactured by Du Pont-Mitsui Fluorochemicals Co., Ltd.; Asahiklin (registered trademark) AC-6000 (1,1,1,2,2,3,3,4,4,5,5,6,6-tridecafluorooctane) manufactured by Asahi Glass Co., Ltd.; and Novec (registered trademark) 7200 (1-ethoxy-nonafluorobutane), Novec (registered trademark) 7500 (3-ethoxy-1,1,1,2,3,4,4,5,5,6,6,6-dodecafluoro-2-(trifluoromethyl)-hexane), Novec (registered trademark) 7600 (1,1,1,2,3,3-hexafluoro-4-(1,1,2,3,3,3-hexafluoropropoxy)-pentane), manufactured by Sumitomo 3M Limited; and the like. If a solvent insoluble melt processable fluoropolymer such as PFA is used, film forming properties of the sheet which is the molded product and flexibility of the obtained sheet can be improved if a small amount of solvent soluble polymer is dissolved in the mixed medium. Various polymers can be used as the solvent soluble polymer, but a solvent soluble fluoropolymer such as fluoroelastomer (fluoroelastomer), polyvinylidene fluoride (PVDF), polyvinyl fluoride (PVF), and other amorphous fluoropolymers are preferably used from the perspective of improving the dispersability of the melt processable fluoropolymer, and thermal resistance and electrical insulating properties of the molded product. Furthermore, from the perspective of flexibility and electrical properties (insulating properties and low dielectric constant) of the molded sheet, a fluoroelastomer (fluoroelastomer) is preferred as the solvent soluble polymer to be added.

In the mixing step of the present invention, the melt processable fluoropolymer as a raw material and other additives and the like as needed are added to the boron nitride particles as described above, and then wet mixed by dispersing in a liquid, and thereby a liquid or slurry mixture can be prepared. Furthermore, the obtained liquid or slurry mixed composition can be used by applying and coating onto a flat substrate. The sheet obtained by coating is preferably melt molded as described below in order to remove voids (spaces). Melt molding eliminates voids and densely fills, and therefore, the heat conductivity and strength of the sheet improves.

Furthermore, in the manufacturing method of the present invention, the boron nitride particles and a powder containing the melt processible fluoropolymer are mixed, or coating as a powder coating is performed by complexing, and then a method of heating to the melting point or higher can be used in the melt molding step described below.

(B) Melt Molding Step

A conventionally known melt molding method such as melt extrusion molding, injection molding, blow molding, transfer molding, melt compression molding, and the like can be used as the melt molding step of the present invention, but in order to not apply a shearing force on the boron nitride particles in the melt processible fluoropolymer composition during molding, the melt extrusion molding and melt compression molding methods are preferable, and the melt compression molding method is more preferable.

Furthermore, if the pressure during the melt compression molding is too high, breaking of the boron nitride aggregates will occur during pressurization, and as a result, the heat conductivity may be reduced. On the other hand, when the pressure is too low, the polymer will not sufficiently fill between the boron nitride particles thereby forming spaces (voids), and therefore, the heat conductivity will be reduced as a result. Specifically, molding is preferably performed at a pressure of 2 to 30 MPa in the melt compression molding step. Furthermore, the melt compression molding step is preferably performed by maintaining a heated state at the melting point or higher. Furthermore, the melt compression molding step is preferably a method of compressing using a metal mold or heat compression roller. Furthermore, a vacuum melt compression molding machine is preferably used because voids can be reduced from the molded product.

In the present invention, because a sheet-shaped molded product is manufactured by heating to the melting point or higher and then melting the melt processible fluoropolymer by melt molding, a sheet without spaces (voids) that is densely filled is formed, and therefore, the heat conductivity and strength of the obtained sheet are improved.

**<4> Physical Property Measurements of Raw Materials**

(1) Melting Point (Melting Peak Temperature)

The melting point of the melt processible fluoropolymer was measured using a differential scanning calorimeter (Pyris Type 1 DSC manufactured by PerkinElmer Co., Ltd.). Approximately 10 mg of a sample was measured, placed in an exclusive use aluminum pan, crimped by an exclusive use crimper, and then stored in the main body of the DCS, and then the temperature was increased from 150°C to 360°C at a rate of 10°C/minute. The melting peak temperature (Tm) was determined from the melting curve obtained at this time.

(2) Melt Flow Rate (MFR)

For the melt flow rate (MFR) of the melt processible fluoropolymer, 5 g of sample powder was filled into a cylinder maintained at $372\pm1$°C, maintained for five minutes, and then extruded through a die orifice under a 5 kg load (piston and weight), and the extrusion rate (g / 10 minutes) at this time was determined as the MFR, in accordance with ASTM D-1238-95, using a melt indexer (manufactured by Toyo Seiki) with a corrosion resistant cylinder, die, and piston.

(3) Definition and Measurement Method of Aspect Ratio

*(A) Aspect Ratio of Spherical Boron Nitride Particles*

The boron nitride particles were observed by scanning electron microscopy (SEM, S-4500 manufactured by Hitachi, Ltd.), and the value of long diameter / short diameter of the particles was set as the aspect ratio (n = 30).

*(B) Aspect ratio of Boron Nitride Anisotropic Particles*

First, the "average particle diameter" of the particles was set as an integrated value 50% (volumetric basis) of the particle diameter distribution, and then measured by a laser diffraction and scattering method. Next, the boron nitride anisotropic particles have a flat plate shape, and therefore, the thickness of the flat plate was measured (n = 30) using scanning electron microscopy, and then the value for "average particle diameter / flat plate thickness" was set as the aspect ratio of the boron nitride anisotropic particles.

**<5> Evaluation Method of the Melt processible**

**fluoropolymer Composition of the Present Invention**

(1) Measurement of Heat Conductivity

Measurement of the heat conductivity of the melt processible fluoropolymer composition was performed using one of the following two methods. In other words, a 1 mm thick sample 1 was measured by (A) a laser flash method, and a 200 $\mu$m thick sample 2 was measured by (B) a unidirectional heat flow steady state comparison method.

*(A) Laser Flash Method (Method A)*

The heat conductivity was evaluated using a molded product where the polymer composition was molded into a circular disk film shape. Specifically, the composition was placed in a predetermined metal mold (dimensions: 55 mm diameter, 30 mm height), the polymer was melted while maintaining at 360°C for 15 minutes, and then compression at a predetermined pressure was performed until the polymer was forced out, cooling was performed for 15 minutes, and then molding into a circular disk with a 55 mm diameter and 1 mm thickness was performed to obtain a molded product (sample 1), using a compression molding machine (Hot Press WFA-37 manufactured by Shinto Metal Industries Corporation, Cylinder diameter: 152 mm).

Furthermore, the heat conductivity in the thickness direction of the circular disk film molded product (sample 1: thickness of 1 mm) was measured using a laser flash heat conductivity measurement device (LFA457 manufactured by NETZSCH), and then the heat conductivity was determined based on the following formula.

Heat conductivity (W/mk) = Heat diffusion rate ($mm^2$/s) x Density (g/$cm^3$) x Specific heat (J/kgK). The density was calculated based on the weight and thickness of the circular disk film.

*(B) Measurement of Heat Conductivity by Unidirectional*

*Heat Flow Steady State Comparison Method (Method B)*

The effective heat conductivity of the film molded product (thickness: 200 $\mu$m: sample 2) cut into a 20 mm square was measured in accordance with a method described in ASTM D5470-1 (steady heat flow method), using a heat conductivity measurement device (TCM1000 manufactured by Rhesca Corporation). At this time, heat conductive silicone grease (Oil Compound G-747 manufactured by Shin-Etsu Chemical Co., Ltd., Heat conductivity: 0.9 W/mk) was applied on both surfaces of the film and then the thickness of the grease layer when set on the device was set at 10 $\mu$m on both surfaces. Furthermore, the grease layer portion was removed, and the heat conductivity of the film molded product itself was calculated based on the following formula, from the value of the obtained effective heat conductivity.

$$[\text{Effective heat conductivity (Entire body)}] = [(\text{Grease layer volume ratio/Grease layer heat conductivity}) + (\text{Film molded product volume ratio/Film molded product heat conductivity})]^{-1}$$

(2) Breakdown Voltage Measurement

The composition was placed in a predetermined metal mold, the polymer was melted while maintaining at 360°C for 15 minutes, and then compression was performed at a predetermined pressure, cooling was performed for 15 minutes, and then molding into a 200 $\mu$m thick plate shape was performed to obtain a molded product (sample 3), using the compression molding machine.

The breakdown voltage was measured at room temperature in accordance with JIS C-2110, using a YSS dielectric breakdown testing machine (No. 175 manufactured by Yasuda Seiki Seisakusho Ltd.).

(3) Measurement of Flexibility

The flexibility of the molded product obtained from the polymer composition was evaluated based on the brittleness evaluation rank by visual observation.

The circular disk molded product (sample 3: 55 mm diameter, 200 $\mu$m thickness) was placed on a horizontal surface, two end parts were held using tweezers, and then the brittleness rank was evaluated based on 4 stages of ◎,

○, Δ, and × from the behavior when both end parts were raised such that the center part of the circle bent.

⊚: Cracking does not occur even if the bending angle was bent to approximately 90° based on visual observation.
○: Cracking occurs when the bending angle is within a range of 45 to 90° based on visual observation.
Δ: Cracking occurs when the bending angle is within a range of 20 to 45° based on visual observation.
×: Cracking occurs when the bending angle is 20° or less based on visual observation.

## EXAMPLES

The following raw materials were used in the examples and comparative examples of the present invention.

## (Used Raw Materials)

(1) Melt processible fluoropolymer

PFA1 MFR: 40 g/10 minutes. Melting point: 304°C. Powder of tetrafluorethylene/perfluoro (propyl vinyl ether) copolymers obtained by emulsion polymerization.

PFA2 MFR: 75 g / 10 minutes. Melting point: 300°C. Powder of tetrafluorethylene / perfluoro (propyl vinyl ether) copolymers obtained by emulsion polymerization.

PFA3 MFR: 12 g / 10 minutes. Melting point: 307°C Powder of tetrafluorethylene / perfluoro (propyl vinyl ether) copolymers obtained by emulsion polymerization.

Fluoroelastomer Du Pont Viton (registered trademark) GF-200S

Vinylidene fluoride - hexafluoropropylene - tetrafluoroethylene - bromide olefin (crosslink point monomer) copolymers. Plate-shaped solid (room temperature).

| (2) Boron Nitride Spherical Aggregate Particles | Average Particle Diameter | Aspect Ratio |
|---|---|---|
| Denki Kagaku Kogyo K.K., SGPS | 12 μm | 1 to 2 |
| Denki Kagaku Kogyo K.K., FP40 | 40 μm | 1 to 2 |
| Denki Kagaku Kogyo K.K., FP70 | 70 μm | 1 to 2 |
| Momentive Performance Materials, PTX60 | 60 μm | 1 to 2 |
| Momentive Performance Materials, AC6091 | 125 μm | 1 to 2 |

| (3) Boron Nitride Anisotropic Particles | Average Particle Diameter | Aspect Ratio |
|---|---|---|
| Denki Kagaku Kogyo K.K., XGP | 30 μm | 150 |
| Momentive Performance Materials, PTX110 | 45 μm | 23 |
| Momentive Performance Materials, PTX120 | 12 μm | 36 |

## Example 1

PFA1 as the melt processible fluoropolymer, boron nitride spherical aggregate particles (A) (average particle diameter: 70 μm), and boron nitride spherical aggregate particles (B) (average particle diameter: 40 μm) were mixed at a volume ratio of 43:54:3, respectively, combined such that the total amount was 30 g, and then dry blending was performed for 15 seconds at room temperature using a coffee mill (BC-1752J manufactured by Yamada Electric IND. Co., Ltd.) to obtain a mixed composition.
The obtained mixed composition was placed in a predetermined metal mold (dimensions: 55 mm diameter, 30 mm height), and then after maintaining at 360°C for 15 minutes using a compression molding machine (hot press WFA-37 manufactured by Shinto Metal Industries Corporation, Cylinder diameter: 152 mm), melt compression molding was performed at an internal pressure (hydraulic) of the compression molding machine of 1 MPa to obtain a molded product sample. The head conductivity (according to method B), breakdown voltage, and flexibility were measured for the obtained molded product sample. The heat conductivity measurement results are shown in Table 1, and the measurement results for the breakdown voltage and flexibility are shown in Table 2. A very favorable result for the heat conductivity of the molded product of 14.3 W/mK was achieved. Note that the content ratio (volume ratio: volume%) on a volumetric basis of the present invention can be determined based on the specific weight of the boron nitride particles, the specific weight of the various polymers to be used, and the weight ratio thereof.

Comparative Example 1

Only the boron nitride spherical aggregate particles (A) (average particles diameter: 70 $\mu$m) was used as the filler. In other words, a composition was prepared using the same method as example 1 except that the PFA1 as the melt processible fluoropolymer and the boron nitride spherical aggregate particles (A) (average particle diameter: 70 $\mu$m) were mixed at a volume ratio of 43:57, respectively, and then a molded sample was prepared and evaluated under the same conditions. The result was that the heat conductivity of the molded product was 7.6 W/mK.

Comparative Example 2

A composition was prepared under the same conditions as comparative example 1, except that boron nitride spherical aggregate particles (average particle diameter: 40 $\mu$m) were used instead of the boron nitride spherical aggregate particles (average particle diameter: 70 $\mu$m), and then a molded sample was prepared and evaluated under the same conditions. The heat conductivity of the molded product was 5.2 W/mK, which was lower than comparative example 1.

Comparative Example 3

A composition was prepared under the same conditions as comparative example 1 other than using boron nitride spherical aggregate particles (average particle diameter: 12 $\mu$m) instead of the boron nitride spherical aggregate particles (average particle diameter: 70 $\mu$m), and then a molded sample was prepared and evaluated under the same conditions. The heat conductivity of the molded product was 4.2 W/mK, which was significantly lower than comparative example 1.

Comparative Example 4

A composition was prepared under the same conditions as comparative example 1 other than using boron nitride spherical aggregate particles (average particle diameter: 125 $\mu$m) instead of the boron nitride spherical aggregate particles (average particle diameter: 70 $\mu$m), and then a molded sample was prepared and evaluated under the same conditions. The heat conductivity of the molded product was 4.7 W/mK, which was lower than comparative example 1.

Comparative Example 5

A composition was prepared under the same conditions as example 1 other than boron nitride spherical aggregate particles (average particle diameter: 125 $\mu$m) were used instead of the boron nitride spherical aggregate particles (A) (average particle diameter: 70 $\mu$m) as a filler, and then a molded sample was prepared and evaluated under the same conditions. The heat conductivity of the molded product was 4.3 W/mK, which was significantly lower than comparative example 1.

Comparative Example 6

A composition was obtained by mixing under the same conditions as example 1, other than reducing the amount of PFA1 from 43% to 27% and increasing the amount of the boron nitride spherical aggregate particles (A) from 54% to 70%, while maintaining the amount of the boron nitride spherical aggregate particles (B) at 3%. Thereafter, the composition was molded, and then a molded product was prepared and evaluated in the same manner. The heat conductivity of the molded product was 4.6 W/mK, which was lower than comparative example 1.

## Example 2

A composition was obtained by mixing under the same conditions as example 1 other than using the boron nitride anisotropic particles (B) (average particle diameter: 30 μm , aspect ratio: 150) in place of the boron nitride spherical aggregate particles (B) (average particle diameter: 40 μm). Thereafter, a composition was molded, and then a molded product was prepared and evaluated in the same manner. A favorable result for the heat conductivity of the molded product of 10.9 W/mK was achieved.

## Example 3

A composition was obtained by mixing under the same conditions as example 1, other than increasing the amount of PFA1 from 43% to 45% and reducing the amount of the boron nitride spherical aggregate particles (B) from 3% to 1%, while maintaining the amount of the boron nitride spherical aggregate particles (A) at 54%. Thereafter, the composition was molded, and then a molded product was prepared and evaluated in the same manner. A favorable result for the heat conductivity of the molded product of 10.9 W/mK was achieved.

## Example 4

A composition was obtained by mixing under the same conditions as example 1, other than reducing the amount of PFA1 from 43% to 40% and increasing the amount of the boron nitride spherical aggregate particles (B) from 3% to 6%, while maintaining the amount of the boron nitride spherical aggregate particles (A) at 54%. Thereafter, the composition was molded, and then a molded product was prepared and evaluated in the same manner. A result of 8.8 W/mK was achieved for the heat conductivity of the molded product, which is more favorable than comparative example 1.

## Example 5

A composition was obtained by mixing under the same conditions as example 1, other than reducing the amount of PFA1 from 43% to 37% and increasing the amount of the boron nitride spherical aggregate particles (A) from 54% to 60%, while maintaining the amount of the boron nitride spherical aggregate particles (B) at 3%. Thereafter, the composition was molded, and then a molded product was prepared and evaluated in the same manner. A favorable result for the heat conductivity of the molded product of 10.4 W/mK was achieved.

## Example 6

A composition was obtained by mixing under the same conditions as example 1, other than increasing the amount of PFA1 from 43% to 47% and reducing the amount of the boron nitride spherical aggregate particles (A) from 54% to 50%, while maintaining the amount of the boron nitride spherical aggregate particles (B) at 3%. Thereafter, the composition was molded, and then a molded product was prepared and evaluated in the same manner. A significantly favorable result for the heat conductivity of the molded product of 11.2 W/mK was achieved.

## Example 7

A composition was obtained by mixing under the same conditions as example 1, other than using a mixture where the amount of PFA-1 was reduced from 43% to 37% and the amount of the boron nitride spherical aggregate particles (B) was increased from 3% to 9%, while maintaining the amount of the boron nitride spherical aggregate particles (A) at 54%. Thereafter, the composition was molded, and then a molded product was prepared and evaluated in the same manner. A very favorable result of 14.7 W/mK was achieved for the heat conductivity of the molded product.

## Example 8

A composition was obtained by mixing under the same conditions as example 1, other than changing the melt processable fluoropolymer from PFA1 to PFA2. Thereafter, the composition was molded, and then a molded product was prepared and evaluated in the same manner. A favorable result of 10.5 W/mK was achieved for the heat conductivity of the molded product.

## Example 9

A composition was obtained by mixing under the same conditions as example 1, other than changing the melt processible fluoropolymer from PFA1 to PFA3. Thereafter, the composition was molded, and then a molded product was prepared and evaluated in the same manner. A comparatively favorable result of 8.1 W/mK was achieved for the heat conductivity of the molded product.

**Example 10**

A composition was obtained by mixing under the same conditions as example 1, other than using the boron nitride spherical aggregate particles (B) (average particle diameter: 12 $\mu$m) in place of the boron nitride spherical aggregate particles (B) (average particle diameter: 40 $\mu$m). Thereafter, the composition was molded, and then a molded product was prepared and evaluated in the same manner. A more favorable result of 8.7 W/mK was achieved for the heat conductivity of the molded product, as compared to comparative example 1.

**Example 11**

A composition was obtained by mixing under the same conditions as example 1, other than using boron nitride spherical aggregate particles (A) (average particle diameter: 60 $\mu$m) in place of the boron nitride spherical aggregate particles (A) (average particle diameter: 70 $\mu$m) and using boron nitride anisotropic particles (B) (average particle diameter: 45 $\mu$m , aspect ratio: 23) in place of the boron nitride spherical aggregate particles (B) (average particle diameter: 40 $\mu$m). Thereafter, the composition was molded, and then a molded product was prepared and evaluated in the same manner. A favorable result of 10.5 W/mK was achieved for the heat conductivity of the molded product.

**Example 12**

A composition was obtained by mixing under the same conditions as example 11, other than using the boron nitride anisotropic particles (B) (average particle diameter: 12 $\mu$m , aspect ratio: 36) in place of the boron nitride anisotropic particles (B) (average particle diameter: 45 $\mu$m, aspect ratio: 23). Thereafter, the composition was molded, and then a molded product was prepared and evaluated in the same manner. A favorable result of 10.2 W/mK was achieved for the heat conductivity of the molded product.

**Example 13**

A composition was obtained by mixing under the same conditions as example 11, other than using the boron nitride spherical aggregate particles (B) (average particle diameter: 40 $\mu$m) in place of the boron nitride anisotropic particles (B) (average particle diameter: 45 $\mu$m, aspect ratio: 23). Thereafter, the composition was molded, and then a molded product was prepared and evaluated in the same manner. A very favorable result of 14.8 W/mK was achieved for the heat conductivity of the molded product.

**Example 14**

PFA1 as the melt processible fluoropolymer, the spherical boron nitride particles (A) (average particle diameter: 70 $\mu$m) as the filler, and the spherical boron nitride particles (B) (average particle diameter: 40 $\mu$m) as the filler were measured at a volume ratio of 43:54:3, and a powder mixture was obtained by dry blending for 15 seconds at room temperature using a coffee mill (BC-1752J manufactured by Yamada Electric Ind. Co., Ltd.).
A fluorine solvent (Vertel (registered trademark) Suprion (trademark): hereinafter, referred to as Suprion) was introduced to the powder mixture such that the solid content concentration was 28 wt%, and then 100 g of a Suprion dispersion was obtained by mixing for five minutes at 2000 rpm using a planetary centrifugal mixer (Awatori Rentaro ARE-250 manufactured by Thinky).
A 50 $\mu$m thick polyimide film that was cut to a 50 mm diameter was laid in a predetermined metal mold (dimensions: 50 mm diameter and 18 mm height) with a cavity part having a depth of 1.16 mm to make the depth of the cavity 1.01 mm. The obtained dispersion was poured into the cavity, and the dispersion in the cavity was adjusted to a uniform height by sliding a metal rod in line with the surface of the cavity upper surface. After drying for 30 minutes at room temperature in a chemical hood, drying was performed for three hours in an oven (SUPER-TEMP. OVEN STPH-101 manufactured by Espec Corporation) set at 200°C. After maintaining for 12 minutes at 400°C using a compression molding machine (hot press WFA-37 manufactured by Shinto Metal Industries Corporation, Cylinder diameter: 152 mm), melt compression molding was performed at a cylinder internal pressure (hydraulic) of the compression molding machine of 1.7 MPa to obtain a molded product sample. The heat conductivity, breakdown voltage, and flexibility were measured for the obtained molded product sample. A very favorable result of 16.0 W/mK was achieved for the heat conductivity of the molded product.

### Example 15

PFA1 as the melt processible fluoropolymer, the spherical boron nitride particles (A) (average particle diameter: 70 μm) as the filler, and the spherical boron nitride particles (B) (average particle diameter: 40 μm) as the filler were measured at a volume ratio of 34.3:54:3, and then a powder mixture was obtained by dry blending for 15 seconds at room temperature using a coffee mill (BC-1752J manufactured by Yamada Electric Ind. Co., Ltd.).

A solution where fluoroelastomer (Du Pont's Viton (registered trademark) GF-200S) was dissolved in a fluorine solvent (Suprion) at a solid content concentration of 5 wt% was prepared in advance, the fluoroelastomer / Suprion solution was measured such that the fluoroelastomer was 8.7 volume% in the final melt processible fluoropolymer composition, and then introduced into the powder mixture, and mixing for five minutes at 2000 rpm was performed using a planetary centrifugal mixer (Awator Rentaro ARE-250 manufactured by Thinky) to obtain 100 g of a Suprion dispersion with a solid content concentration of 28.5 wt%.

A 50 μm thick polyimide film that was cut to a 50 mm diameter was laid in a predetermined metal mold (dimensions: 50 mm diameter and 18 mm height) with a cavity portion having a depth of 1.16 mm to make the depth of the cavity 1.01 mm. The obtained dispersion was poured into the cavity, and the dispersion in the cavity was adjusted to a uniform height by sliding a metal rod in line with the surface of the cavity upper surface. After drying for 30 minutes at room temperature in a chemical hood, drying was performed for three hours in an oven (SUPER-TEMP. OVEN STPH-101 manufactured by Espec Corporation) set at 200°C. After maintaining for 12 minutes at 400°C using a compression molding machine (hot press WFA-37 manufactured by Shinto Metal Industries Corporation, Cylinder diameter: 152 mm), melt compression molding was performed at a cylinder internal pressure (hydraulic) of the compression molding machine of 1 MPa, and then the heat conductivity, breakdown voltage, and flexibility was measured for the obtained molded product sample. A favorable result of 10.7 W/mK was achieved for the heat conductivity of the molded product.

The compositions of examples 1 through 15 and comparative examples 1 through 6 as well as the evaluations results for the heat conductivity are shown in the following Table 1.

Table 1: Composition and heat conductivity of the present invention

Composition ratio (Vol%)

| | Melt processible fluoropolymer | | | | Boron nitride | | | | | | | | | BN total | (Total) | | Heat conductivity |
|---|---|---|---|---|---|---|---|---|---|---|---|---|---|---|---|---|---|
| | | | | | Spherical aggregate particles — Average particle diameter [μm] | | | | | Anisotropic particles — Average particle diameter [μm] | | | | | BN (A) | BN (B) | |
| | PFA1 | PFA2 | PFA3 | Fluorine rubber | 12 | 40 | 70 | 60 | 125 | 30 | 45 | 12 | | vol% | ratio% | ratio% | W/mK |
| Example 1 | 43 | | | | | 3 | 54 | | | | | | | 57 | 95% | 5% | 14.3 |
| Comparative Example 1 | 43 | | | | | | 57 | | | | | | | 57 | 100% | | 7.6 |
| Comparative Example 2 | 43 | | | | | 57 | | | | | | | | 57 | | 100% | 5.2 |
| Comparative Example 3 | 43 | | | | 57 | | | | | | | | | 57 | | 100% | 4.2 |
| Comparative Example 4 | 43 | | | | | | | | 57 | | | | | 57 | | | 4.7 |
| Comparative Example 5 | 43 | | | | | 3 | | | 54 | | | | | 57 | 95% | 5% | 4.3 |
| Comparative Example 6 | 27 | | | | | 3 | 70 | | | | | | | 73 | 96% | 4% | 4.6 |
| Example 2 | 43 | | | | | | 54 | | | 3 | | | | 57 | 95% | 5% | 10.9 |
| Example 3 | 45 | | | | | 1 | 54 | | | | | | | 55 | 98% | 2% | 10.9 |
| Example 4 | 40 | | | | | 6 | 54 | | | | | | | 60 | 90% | 10% | 8.8 |
| Example 5 | 37 | | | | | 3 | 60 | | | | | | | 63 | 95% | 5% | 10.4 |
| Example 6 | 47 | | | | | 3 | 50 | | | | | | | 53 | 94% | 6% | 11.2 |
| Example 7 | 37 | | | | | 9 | 54 | | | | | | | 63 | 86% | 14% | 14.7 |
| Example 8 | | 43 | | | | 3 | 54 | | | | | | | 57 | 95% | 5% | 10.5 |
| Example 9 | | | 43 | | | 3 | 54 | | | | | | | 57 | 95% | 5% | 8.1 |
| Example 10 | 43 | | | | 3 | | 54 | | | | | | | 57 | 95% | 5% | 8.7 |

(continued)

| | Composition ratio (Vol%) | | | | | | | | | | | | | (Total) | | | |
| | Melt processible fluoropolymer | | | | Boron nitride | | | | | | | | BN total | | | | |
| | | | | | Spherical aggregate particles | | | | | Anisotropic particles | | | | | | | Heat conductivity |
| | PFA1 | PFA2 | PFA3 | Fluorine rubber | Average particle diameter [$\mu$m] | | | | | Average particle diameter [$\mu$m] | | | vol% | BN (A) | BN (B) | |
| | | | | | 12 | 40 | 70 | 60 | 125 | 30 | 45 | 12 | | ratio% | ratio% | W/mK |
| Example 11 | 43 | | | | | | | 54 | | | 3 | | 57 | 95% | 5% | 10.5 |
| Example 12 | 43 | | | | | | | 54 | | | | 3 | 57 | 95% | 5% | 10.2 |
| Example 13 | 43 | | | | | 3 | | 54 | | | | | 57 | 95% | 5% | 14.8 |
| Example 14 | 43 | | | | | 3 | 54 | | | | | | 57 | 95% | 5% | 16.0 |
| Example 15 | 34.3 | | | 8.7 | | 3 | 54 | | | | | | 57 | 95% | 5% | 10.7 |

Furthermore, the evaluation results for the breakdown voltage and flexibility tests for the samples of examples 1 through 15 and comparative examples 1 through 6 were collected and shown in the following Table 2.

Table 2: Breakdown voltage and flexibility evaluation result

| | Heat conductivity W/mK | Breakdown voltage [kV] | Brittleness rank |
|---|---|---|---|
| Example 1 | 14.3 | 10 | ○ |
| Example 2 | 10.9 | 6.5 | ○ |
| Example 3 | 10.9 | 8.2 | ○ |
| Example 4 | 8.8 | - | Δ |
| Example 5 | 10.4 | 7.5 | Δ |
| Example 6 | 11.2 | 7.8 | ○ |
| Example 7 | 14.7 | 5.2 | Δ |
| Example 8 | 10.5 | 7 | ○ |
| Example 9 | 8.1 | 6.5 | ◎ |
| Example 10 | 8.7 | 7.2 | ○ |
| Example 11 | 10.5 | - | ○ |
| Example 12 | 10.2 | - | ○ |
| Example 13 | 14.8 | 5.7 | ○ |
| Example 14 | 16.0 | 9.1 | ○ |
| Example 15 | 10.7 | 7 | ◎ |
| Comparative Example 1 | 7.6 | 7.5 | ○ |
| Comparative Example 6 | 4.6 | - | × |

Based on the comparison between example 1 and comparative example 1, the heat conductivity, insulation effect, and flexibility all improved by using in combination the two types of boron nitride particles (A) and the boron nitride particles (B) as a filler.

When the ratio of the melt processible fluoropolymer is relatively reduced as in examples 4, 5, and 7, there is a tendency for the effects to be reduced in the flexibility measurement.

Furthermore, in comparing examples 1, 8 and 9, a composition with an MFR of 40 g / 10 minutes has the most favorable heat conductivity, and if the value is higher or lower than this value, the heat conductivity will be slightly reduced.

Furthermore, in comparing examples 1, 8, and 9, the molded product of example 9 is most excellent in flexibility. The brittleness of the molded product is believed to be enhanced by using a melt processible fluoropolymer with a low MFR, in other words, a high molecular weight.

If the molded product of the present invention is used as a heat dissipating material for electronic components, particularly a dissipating material for power semiconductors / power modules, very high insulating properties are required. Therefore, the breakdown voltage (measured value) of the molded product must be at least 5 kV or higher, preferably 7 kV of higher, and more preferably 9 kV or higher. The breakdown voltage affects the physical properties, dispersion state, and the like of the filler included in the polymer composition, but in examples 1, 3, 6, and 14, a particularly favorable insulation effect was observed.

In particular, in example 14, the heat conductivity was very excellent. This is believed to be because the polymer and boron nitride particles were densely dispersed without destroying the boron nitride particles, due to wet mixing using a fluorine solvent.

Based on the results of example 15, the flexibility of the molded sheet is believed to be enhanced by changing a portion of the PFA1 to fluoroelastomer as the melt processible fluoropolymer.

In examples 14 and 15, molding the sheet by coating a mixed composition using wet mixing has an advantage of improving the efficiency of manufacturing.

### Example 16

The composition prepared in example 1 was used to obtain a 1 mm thick molded product sample under the same conditions, other than changing the cylinder internal pressure of the compression molding machine from 1 MPa to 2 MPa. The heat conductivity (according to method A), breakdown voltage, and flexibility were measured for the obtained molded product sample. A favorable result of 10.3 W/mK was achieved for the heat conductivity of the molded product.

### Example 17

The composition prepared in example 2 was used to obtain a 1 mm thick molded product sample under the same conditions, and then measurements were performed using the same method A as example 16. A favorable result of 10.4 W/mK was achieved for the heat conductivity of the molded product.

### Example 18

The composition prepared in example 11 was used to obtain a 1 mm thick molded product sample under the same conditions other than changing the cylinder internal pressure of the compression molding machine from 1 MPa to 2 MPa,. A favorable result of 9.9 W/mK was achieved for the heat conductivity (according to method A) of the molded product.

The compositions of examples 16 through 18 and the evaluations results of the heat conductivity are summarized in the following Table 3.

Table 3: Composition and heat conductivity of the present invention

| | Composition ratio (Vol%) | | | | | | | | |
| | Melt processible fluoropolymer | Boron nitride | | | (Total) | | | | |
| | | Spherical aggregate particles | | Anisotropic particles | BN total | | | Compression molding machine cylinder inner pressure | Heat conductivity (method A) |
| | PFA 1 | Average particle diameter [μm] | | Average particle diameter [μm] | | BN (A) | BN (B) | | |
| | | 40 μm | 70 μm | 30 μm | vol% | ratio% | ratio% | [MPa] | [W/mK] |
| Example 16 | 43 | 3 | 54 | | 57 | 95% | 5% | 2 | 10.3 |
| Example 17 | 43 | | 54 | 3 | 57 | 95% | 5% | 1 | 10.4 |
| Example 18 | 43 | | 54 | 3 | 57 | 95% | 5% | 2 | 9.9 |

Based on the comparison between example 17 and example 18, when the melt molding pressure is too high, the heat conductivity tends to be slightly reduced. This is believed to be an effect where a portion of the boron nitride particles is destroyed when too high of a pressure is applied when molding.

## POSSIBILITY OF INDUSTRIAL APPLICATION

The molded product manufactured from the melt processible fluoropolymer composition of the present invention has high heat conductivity and insulating properties, is more flexible than a ceramic, and is light weight. Furthermore, the melt processible fluoropolymer composition of the present invention can be molded into a thin sheet of 100 to 300 $\mu$m , and therefore, is useful as a dissipating material for electronic components, particularly dissipating materials that propagates generated heat from a power semiconductor to a cooling part. Furthermore, the molded product of the present invention quickly removes frictional heat, and therefore, is useful as a sliding member, or as a material / cell seal of a LED substrate or electronic substrate.

## Claims

1.  A polymer composition, comprising:

    30 to 60 volume% of a melt processible fluoropolymer; and
    40 to 70 volume% boron nitride particles; wherein
    the boron nitride particles are made from particles (A) and particles (B),
    the particles (A) are spherical aggregate particles with an average particle diameter of 60 $\mu$m or higher to 100 $\mu$m, and an aspect ratio of 1 to 2,
    the particles (B) are particles with an average particle diameter of 8 to less than 50 $\mu$m,
    wherein the average particle diameter refers to the particle diameter at an integrated value of 50 vol.% of the particle diameter distribution obtained by a laser diffraction and scattering method, and
    the volume ratio of the particles (A) to the total amount of boron nitride is 80 to 99 volume%.

2.  The polymer composition according to claim 1, wherein the boron nitride particles (B) are spherical aggregate particles with an aspect ratio of 1 to 2.

3.  The polymer composition according to claim 1 or 2, wherein the melt flow rate (MFR) of the melt processible fluoropolymer is within a range of 1 to 100 g / 10 minutes.

4.  The polymer composition according to any one of claims 1 through 3, wherein the fluoropolymer is a perfluoropolymer.

5.  The polymer composition according to any one of claims 1 through 4, wherein the ratio of the melt processible fluoropolymer is 35 to 50 volume%, and the ratio of the boron nitride particles is 50 to 65 volume%.

6.  The polymer composition according to any one of claims 1 through 5, wherein the average particle diameter of the particles (A) is 60 to 90 $\mu$m and the average particle diameter of the particles (B) is 10 to 50 $\mu$m.

7.  A molded product manufactured from the melt processible fluoropolymer composition according to claims 1 through 6.

8.  A sheet-shaped molded product according to claim 7 with a thickness within a range of 100 to 300 $\mu$m.

9.  A method of manufacturing a sheet-shaped molded product, comprising:

    a step of mixing melt processible fluoropolymer and boron nitride particles at a ratio of 30 to 60 volume% to 40 to 70 volume%, the boron nitride particles including particles (A) and particles (B),
    particles (A) are spherical aggregate particles with an average particle diameter of 60 $\mu$m or higher to 100 $\mu$m, and an aspect ratio of 1 to 2, particles (B) are particles with an average particle diameter of 8 to less than 50 $\mu$m, wherein the average particle diameter refers to the particle diameter at an integrated value of 50 vol.% of the particle diameter distribution obtained by a laser diffraction and scattering method, and the volume ratio of the particles (A) to the total amount of boron nitride is 80 to 99 volume%; and
    a step of melt molding the mixed melt processible fluoropolymer to obtain a sheet-shaped molded product.

**Patentansprüche**

1. Polymerzusammensetzung, umfassend:

   30 bis 60 Volumen-% eines schmelzverarbeitbaren Fluopolymers; und
   40 bis 70 Volumen-% Bornitridteilchen; wobei
   die Bornitridteilchen aus Teilchen (A) und Teilchen (B) hergestellt sind,
   die Teilchen (A) kugelförmige angehäufte Teilchen mit einem durchschnittlichen Teilchendurchmesser von 60 $\mu$m oder höher bis zu 100 $\mu$m und einem Seitenverhältnis von 1 zu 2 sind,
   die Teilchen (B) Teilchen mit einem durchschnittlichen Teilchendurchmesser von 8 bis weniger als 50 $\mu$m sind, wobei der durchschnittliche Teilchendurchmesser sich auf den Teilchendurchmesser bei einem integrierten Wert von 50 Vol.-% der Teilchendurchmesserverteilung bezieht, die durch ein Laserbeugungs- und -streuungsverfahren erhalten wird, und
   das Volumenverhältnis der Teilchen (A) zu der Gesamtmenge an Bornitrid 80 bis 99 Volumen-% beträgt.

2. Polymerzusammensetzung nach Anspruch 1, wobei die Bornitridteilchen (B) kugelförmige angehäufte Teilchen mit einem Seitenverhältnis von 1 zu 2 sind.

3. Polymerzusammensetzung nach Anspruch 1 oder 2, wobei die Schmelzfließrate (MFR) des schmelzverarbeitbaren Fluopolymers innerhalb eines Bereichs von 1 bis 100 g/10 Minuten liegt.

4. Polymerzusammensetzung nach irgendeinem der Ansprüche 1 bis 3, wobei das Fluorpolymer ein Perfluorpolymer ist.

5. Polymerzusammensetzung nach irgendeinem der Ansprüche 1 bis 4, wobei das Verhältnis des schmelzverarbeitbaren Fluopolymers 35 bis 50 Volumen-% beträgt und das Verhältnis der Bornitridteilchen 50 bis 65 Volumen-% beträgt.

6. Polymerzusammensetzung nach irgendeinem der Ansprüche 1 bis 5, wobei der durchschnittliche Teilchendurchmesser der Teilchen (A) 60 bis 90 $\mu$m beträgt und der durchschnittliche Teilchendurchmesser der Teilchen (B) 10 bis 50 $\mu$m beträgt.

7. Geformtes Produkt, das aus der schmelzverarbeitbaren Fluopolymerzusammensetzung nach den Ansprüchen 1 bis 6 hergestellt wird.

8. Plattenförmiges geformtes Produkt nach Anspruch 7 mit einer Dicke innerhalb eines Bereichs von 100 bis 300 $\mu$m.

9. Verfahren für die Herstellung eines plattenförmigen geformten Produkts, umfassend:

   einen Schritt des Mischens des schmelzverarbeitbaren Fluopolymers und der Bornitridteilchen in einem Verhältnis von 30 bis 60 Volumen-% zu 40 bis 70 Volumen-%, wobei die Bornitridteilchen Teilchen (A) und Teilchen (B) enthalten, die Teilchen (A kugelförmige angehäufte Teilchen mit einem durchschnittlichen Teilchendurchmesser von 60 $\mu$m oder höher bis zu 100 $\mu$m und einem Seitenverhältnis von 1 zu 2 sind, die Teilchen (B) Teilchen mit einem durchschnittlichen Teilchendurchmesser von 8 bis weniger als 50 $\mu$m sind, wobei der durchschnittliche Teilchendurchmesser sich auf den Teilchendurchmesser bei einem integrierten Wert von 50 Vol.-% der Teilchendurchmesserverteilung bezieht, die durch ein Laserbeugungs- und -streuungsverfahren erhalten wird, und das Volumenverhältnis der Teilchen (A) zu der Gesamtmenge an Bornitrid 80 bis 99 Volumen-% beträgt; und
   einen Schritt des Schmelzformens des gemischten schmelzverarbeitbaren Fluopolymers, um ein plattenförmiges geformtes Produkt zu erhalten.

**Revendications**

1. Composition polymère, comprenant:

   de 30 à 60 % en volume d'un polymère fluoré pouvant être transformé à l'état fondu; et
   de 40 à 70 % en volume de particules de nitrure de bore;
   les particules de nitrure de bore étant constituées de particules (A) et de particules (B),

les particules (A) étant des particules d'agrégat sphériques avec un diamètre moyen de particule de 60 $\mu$m ou plus à 100 $\mu$m, et un rapport longueur sur largeur de 1 à 2,

les particules (B) étant des particules ayant un diamètre moyen de particule de 8 à moins de 50 $\mu$m,

le diamètre moyen de particule désignant le diamètre de particule à une valeur intégrée de 50 % en volume de la distribution des diamètres de particules obtenue selon un procédé de diffraction et de diffusion laser, et

le rapport en volume des particules (A) à la quantité totale de nitrure de bore étant de 80 à 99 % en volume.

2. Composition polymère selon la revendication 1, les particules de nitrure de bore (B) étant des particules d'agrégat sphériques présentant un rapport longueur sur largeur de 1 à 2.

3. Composition polymère selon la revendications 1 ou 2, le débit d'écoulement à l'état fondu (MFR) du polymère fluoré pouvant être transformé à l'état fondu se situant dans une plage de 1 à 100 g/10 minutes.

4. Composition polymère selon l'une quelconque des revendications 1 jusqu'à 3, le polymère fluoré étant un polymère perfluoré.

5. Composition polymère selon l'une quelconque des revendications 1 jusqu'à 4, le rapport du polymère fluoré pouvant être transformé à l'état fondu étant de 35 à 50 % en volume, et le rapport des particules de nitrure de bore étant de 50 à 65 % en volume.

6. Composition polymère selon l'une quelconque des revendications 1 jusqu'à 5, le diamètre moyen de particule des particules (A) étant de 60 à 90 $\mu$m et le diamètre moyen de particule des particules (B) étant de 10 à 50 $\mu$m.

7. Produit moulé fabriqué à partir de la composition de polymère fluoré pouvant être transformé à l'état fondu selon les revendications 1 jusqu'à 6.

8. Produit moulé en forme de feuille selon la revendication 7 présentant une épaisseur se situant dans une plage de 100 à 300 $\mu$m.

9. Procédé de fabrication d'un produit moulé en forme de feuille, comprenant:

une étape de mélange du polymère fluoré pouvant être transformé à l'état fondu et des particules de nitrure de bore sous un rapport de 30 à 60 % en volume à 40 à 70 % en volume, les particules de nitrure de bore comprenant les particules (A) et les particules (B), les particules (A) étant des particules d'agrégat sphériques ayant un diamètre moyen de particule de 60 $\mu$m ou plus à 100 $\mu$m, et un rapport longueur sur largeur de 1 à 2, les particules (B) étant des particules ayant un diamètre moyen de particule de 8 à moins de 50 $\mu$m, le diamètre moyen de particule désignant le diamètre de particule à une valeur intégrée de 50 % en volume de la distribution des diamètres de particules obtenue selon un procédé de diffraction et de diffusion laser, et le rapport en volume des particules (A) à la quantité totale de nitrure de bore étant de 80 à 99 % en volume; et

une étape de moulage à l'état fondu du polymère fluoré mélangé pouvant être transformé à l'état fondu pour obtenir un produit moulé en forme de feuille.

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2014235955 A
- JP 3461651 B
- JP 2010137562 A
- JP 2013023664 A
- JP 2005343728 A
- JP 2012056818 A
- JP 5305656 B